# EUROPEAN PATENT SPECIFICATION

(11) **EP 1 588 178 B1**
(45) Date of publication and mention of the grant of the patent: **12.10.2011**
(21) Application number: 04703580.3
(22) Date of filing: 20.01.2004
(51) Int. Cl.: G01R 33/28

(54) **METHOD OF PRODUCING OPTICALLY PUMPED HYPERPOLARIZED GAS**
VERFAHREN ZUR HERSTELLUNG EINES OPTISCH GEPUMPTEN HYPERPOLARISIERTEN GASES
PROCEDE DE PRODUCTION D'UN GAZ HYPERPOLARISE PAR POMPAGE OPTIQUE

(30) Priority: 17.01.2003 US 440780 P
(43) Date of publication of application: 26.10.2005
(73) Proprietor: Medi-Physics Inc., Princeton, NJ 08540 (US)
(72) Inventor: CELLA, Patrick, A., Raleigh, NC 27614 (US)
(74) Representative: Canning, Lewis R.
(86) International application number: PCT/US2004/001299
(87) International publication number: WO 2004/065975

(56) References cited:
- US-A- 6 134 913
- US-A1- 2003 077 224
- US-B1- 6 430 960
- ZOOK A L ET AL: "High capacity production of >65% spin polarized xenon-129 for NMR spectroscopy and imaging" JOURNAL OF MAGNETIC RESONANCE, ACADEMIC PRESS, ORLANDO, FL, US, vol. 159, no. 2, December 2002 (2002-12), pages 175-182, XP004408126 ISSN: 1090-7807

## Description

### Field of the Invention

The present invention relates to the production of polarized noble gases that are particularly useful for NMR and magnetic resonance imaging ("MRI") applications.

### Background of the Invention

Polarized inert noble gases can produce improved MRI images of certain areas and regions of the body that have heretofore produced less than satisfactory images in this modality. Polarized helium-3 ("³He") and xenon-129 ("¹²⁹Xe") have been found to be particularly suited for this purpose. Unfortunately, as will be discussed further below, the polarized state of the gases is sensitive to handling and environmental conditions and can, undesirably, decay from the polarized state relatively quickly.

Hyperpolarizers are used to produce and accumulate polarized noble gases. Hyperpolarizes artificially enhance the polarization of certain noble gas nuclei (such as ¹²⁹Xe or ³the) over the natural or equilibrium levels, *i.e.,* the Boltzmaunn polarization. Such an increase is desirable because it enhances and increases the MRI signal intensity, allowing physicians to obtain better images of the substance in the body. *See* U. S. Patent Nos. 5,545,396; 5,642,625; 5,809,801; 6,079,213, and 6,295,834

In order to produce the hyperpolarized gas, the noble gas is typically blended with optically pumped alkali metal vapors such as rubidium ("Rb"). These optically pumped metal vapors collide with the nuclei of the noble gas and hyperpolarize the noble gas through a phenomenon known as "spin-exchange." The "optical pumping" of the alkali metal vapor is produced by irradiating the alkali-metal vapor with circularly polarized light at the wavelength of the first principal resonance for the alkali metal (*e.g*., 795 nm for Rb). Generally stated, the ground state atoms become excited, then subsequently decay back to the ground state. Under a modest magnetic field (1mT 10 Gauss), the cycling of atoms between the ground and excited states can yield nearly 100% polarization of the atoms in a few microseconds. This polarization is generally carried by the lone valence electron characteristics of the alkali metal. In the presence of non-zero nuclear spin noble gases, the alkali-metal vapor atoms can collide with the noble gas atoms in a manner in which the polarization of the valence electrons is transferred to the noble-gas nuclei through a mutual spin flip "spin-exchange."

Generally stated, as noted above, conventional hyperpolarizers include an optical pumping chamber held in an oven and in communication with a laser source that is configured and oriented to transmit circularly polarized light into the optical pumping chamber during operation. The hyperpolarizers may also monitor the polarization level achieved at the polarization transfer process point, *i.e.,* at the optical cell or optical pumping chamber. In order to do so, typically a small "surface" NMR coil can be positioned adjacent the optical pumping chamber to excite and detect the gas therein and thus monitor the level of polarization of the gas during the polarization-transfer process. *See* U.S. Patent No. 6,295,834 disclosing a method of heating a noble gas/alkali metal mixture in an optical pumping cell and polarizing the noble gas via spin-exchange with the alkali metal. The polarized gas is directed out of the pumping cell to a storage reservoir.

On-board hyperpolarizer monitoring equipment no longer requires high-field NMR equipment, but instead can use low-field detection techniques to perform polarization monitoring for the optical cell at much lower field strengths (*e.g*., 0.1-10mT, 100G)) than conventional high-field NMR techniques. This lower field strength allows correspondingly lower detection equipment operating frequencies, such as 1-400kHz. Saam et al. has proposed a low-frequency NMR circuit expressly for the on-board detection of polarization levels for hyperpolarized ³He at the optical chamber or cell inside the temperature-regulated oven that encloses the cell. *See* Saam et al., Low Frequency NMR Polarimeter for Hyperpolarized Gases, Jnl. of Magnetic Resonance 134, 67-71 (1998)

Polarizing the target gas using spin exchange optical pumping is a relatively slow process; it can take about 10 -16 hours, or longer, for a 1-liter batch of polarized helium gas to reach or approach its saturation polarization in conventionally sized polarization cells. Using larger volume cells can require larger ovens, more laser power, and stronger optics than those conventionally used.

Thus, there remains a need for methods and systems that can provide increased volume production of polarized gas.

### Summary of the Invention

In view of the foregoing, the present invention provides
a method for producing hyperpolarized gas, comprising:
   heating an optical pumping cell containing a noble gas and an alkali metal, the optical pumping cell having an exit port residing in a top portion of the optical pumping cell and an inlet port positioned about a bottom portion of the optical pumping cell, the optical pumping cell being connected, by means of a gas flow path, to a storage reservoir having separate exit and inlet ports, the gas flow path extending from the optical pumping cell exit port to the reservoir inlet port and the reservoir exit port to the optical pumping cell inlet port ;
   optically pumping, within a magnetic field, the alkali metal in the optical pumping cell, so that the noble gas in the optical pumping cell becomes nuclear spin polarized *via* spin-exchange with the optically pumped alkali metal;
   directing heated polarized gas to flow out of the top portion of the optical pumping cell *via* said gas flow path and the inlet port of the storage reservoir into a storage reservoir, the storage reservoir having a temperature that is less than the temperature of the optical pumping chamber and the storage reservoir having a greater volume than the optical pumping cell, wherein said directing is carried out using only convective heating of the polarized target gas;
   automatically monitoring the polarization level of the polarized gas in one or both of the optical pumping cell and the storage reservoir ;
   dispensing polarized gas from a dispensing port positioned on the reservoir or at a location of the gas flow path downstream of the storage reservoir in advance of the optical pumping cell;
   directing previously polarized gas from the storage reservoir, not dispensed via the dispensing port, back into the optical pumping cell *via* said gas flow path and said inlet port of the optical pumping cell and,
   generating a magnetic holding field that covers the optical pumping cell (20) the reservoir and the gas flow path (40);
   a polarizing system for polarizing a noble gas *via* spin-exchange with an optically pumped alkali metal, comprising:
   an optical pumping cell having an exit port residing on a top portion of the optical pumping cell and an inlet port positioned about a bottom portion of the optical pumping cell;
   a storage reservoir in fluid communication with the optical pumping cell , the reservoir having separate exit and inlet ports, wherein the reservoir has a larger volume than the optical pumping cell;
   a gas flow path extending from the optical pumping cell exit port to the storage reservoir inlet port and the storage reservoir exit port to the optical pumping cell inlet port;
   means aranged to generate a magnetic holding field covering the optical pumping cell, the reservoir and the gas flow path;
   an optic system arranged to generate and transmit polarized light for optical pumping an alkali metal within the optical pumping cell;
   means for heating said optical pumping cell such that said optical pumping cell can be held at a temperature that is larger than the temperature of the storage reservoir;
   a controller configured to automatically monitor the polarization level of the polarized gas in one or both of the optical pumping cell and the reservoir ; and,
   a dispensing port for dispensing polarized noble gas, positioned on the reservoir or at a location in the gas flow path downstream of the storage reservoir in advance of the optical pumping cell, so that, in operation, noble gas polarized in the optical pumping cell convectively flows out of the optical pumping cell inlet port *via* the gas flow path and the storage reservoir inlet port to the storage reservoir; and previously polarized noble gas which as not been dispensed via the dispensing port automatically flows from the storage reservoir back into the optical pumping cell *via* the gas flow path and said optical pumping inlet port.

Advantageously, the present invention can provide increased timely production of hyperpolarized gas where reservoirs can hold individual patient-sized quantities (such as 0.5-2 liters) of polarized gas while the optical pumping cell is operating to produce a fresh supply of polarized gas. Unlike batch type production processes, during operation, the systems and methods provided by the instant invention can substantially continuously recirculate polarized gas and/or dispense and supply fresh target gas as desired to provide increased amounts of polarized gas using a polarization cell that is sized similar to conventional cells.

The foregoing and other objects and aspects of the present invention are explained in detail herein.

### Brief Description of the Drawings

**Figure 1** is a block diagram of operations that can be used to carry out embodiments of the present invention.
**Figure 2** is a schematic illustration of a polarizer system having an optical pumping cell with a closed loop flow path for circulating polarized gas according to embodiments of the present invention.
**Figure 3** is a schematic illustration of a polarizer system similar to that shown in Figure 2, but with the reservoir located below the optical cell, according to embodiments of the present invention.
**Figure 4** is a schematic illustration of a polarizer system according to other embodiments of the present invention.
**Figure 5** is a block diagram of a computer module for use with convectively discharged gas
**Figure 6** is a front partially cutaway view of a solenoid configured to provide a magnetic field according to embodiments of the present invention.

### Detailed Description of Embodiments of the Invention

The present invention will now be described more fully hereinafter with reference to the accompanying figures, in which preferred embodiments of the invention are shown. This invention may, however, be embodied in many different forms and should not be construed as limited to the embodiments set forth herein. Like numbers refer to like elements throughout. In the drawings, layers, regions, or components may be exaggerated for clarity. In the figures, broken linens indicate optional features unless described otherwise.

In the description of the present invention that follows, certain terms may be employed to refer to the positional relationship of certain structures relative to other structures. As used herein the term "forward" and derivatives thereof refer to the general direction the target gas or target gas mixture travels as it moves through the hyperpolarizer system; this term is meant to be synonymous with the term "downstream," which is often used in manufacturing environments to indicate that certain material being acted upon is farther along in the manufacturing process than other material. Conversely, the terms "rearward" and "upstream" and derivatives thereof refer to the directions opposite, respectively, the forward and downstream directions.

Also, as described herein, polarized gases are produced and collected and may, in particular embodiments, be frozen, thawed, be used alone and/or combined with other constituents, for MRI and/or NMR spectroscopy applications. For ease of description, the term "frozen polarized gas" means that the polarized gas has been frozen into a solid state. The term "liquid polarized gas" means that the polarized gas has been or is being liquefied into a liquid state. Thus, although each term includes the word "gas," this word is used to name and descriptively track the gas that is produced via a hyperpolarizer to obtain a polarized "gas" product. Thus, as used herein, the terms "gas" or "target gas" may be used in certain places to descriptively indicate a hyperpolarized noble gas product and may be used with modifiers such as "solid", "frozen", and "liquid" to describe the state or phase of that product. As also used herein, the terms "polarized gas", "target gas" and/or "polarized target gas" include at least one intended target gas of interest (such as, but not limited to, ³He and/or ¹²⁹Xe) and may include one or more other constituents such as other carrier or blending gases, buffer gases, or carrier liquids as desired. Further, the terms "polarize", "polarizer", "polarized", and the like are used interchangeably with the terms "hyperpolarize", "hyperpolarizer", "hyperpolarized" and the like.

Various techniques have been employed to accumulate and capture polarized gases. For example, U.S. Patent No. 5,642,625 to Cates et al. describes a high volume hyperpolarizer for spin -exchange polarized noble gas and U.S. Patent No. 5,809,801 to Cates et al. describes a cryogenic accumulator for spin-polarized ¹²⁹Xe. As used herein, the terms "hyperpolarize," "polarize," and the like, are used interchangeably and mean to artificially enhance the polarization of certain noble gas nuclei over the natural or equilibrium levels. Such an increase is desirable because it allows stronger imaging signals corresponding to better MRI images of the substance and a targeted area of the body. As is known by those of skill in the art, hyperpolarization can be induced by spin-exchange with an optically pumped alkali-metal vapor or alternatively by metastability exchange. *See* Albert et al., U.S. Patent No. 5,545,396.

Generally described, hyperpolarizer systems include optic systems with a laser source, such as a diode laser array, and optic beam forming or focusing components, such as beam splitters, lenses, mirrors or reflectors, beam or wave polarizers or wave shifters, and/or other focal components for providing the circularly polarized light source to the target gas held in an optical pumping cell. For ease of description, the term "optic system" as used herein includes the optical pumping components used to generate and/or focus the circularly polarized light.

Generally described, operations of the present invention are carried out using temperature differentials to provide a convection-induced discharge of polarized gas from the optical pumping cell to thereby cause the polarized gas to rise out of the optical pumping cell and flow to a reservoir. The systems include a closed loop circulating gas flow path that connects the optical pumping cell and the reservoir and allows gas in the reservoir to travel back to the optical pumping cell to be re-polarized as needed.

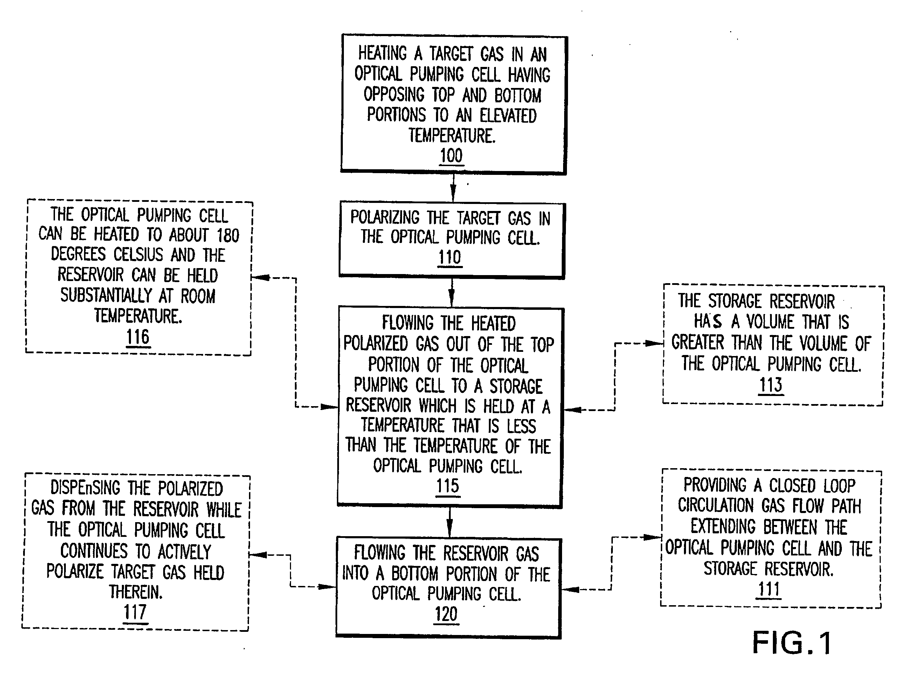

**Figure 1** illustrates operations that can be used to carry out embodiments of the present invention. A target gas can be heated in an optical pumping cell that has opposing top and bottom portions **(block 100)**. The target gas can be polarized in the optical pumping cell **(block 110)**. The heating can be carried out using any suitable energy source or sources, such as by using one or more of: (a) the laser energy used to optically pump the target gas; (b) a strip or plate heater; (c) an oven encasing the optical pumping cell; or (d) another desired heat-inducing source. The optical pumping cell (and gas therein) can be heated to at least about 150 degrees Celsius, and typically to about 180 degrees Celsius **(block 116)**, and the reservoir can be at approximately room temperature.

In any event, the heated polarized gas flows out of the top portion of the optical pumping cell to a storage reservoir which is held at a temperature that is less (below) that of the optical pumping cell **(block 115)**. The reservoir gas is flowable back into the optical pumping cell **(block 120)** at a location that is different from where the gas flows out of the pumping cell. In accordance with the invention, the reservoir gas is directed to flow into a bottom portion of the pumping cell

However, the location of the inlet should be spaced apart a vertical distance from the outlet sufficient to allow only the more recently polarized (heated) gas to exit the outlet port.

The storage reservoir is sized and configured with a volume greater than that of the optical pumping cell **(block 113)**. In certain particular embodiments, the optical pumping cell may have an internal volume of about 250 cc's and the reservoir can have an internal volume of between about 250-1000 cc's.

A closed loop gas circulating flow path is configured to extend between the optical pumping cell and the reservoir **(block 111)**.
The polarized gas can be dispensed from the reservoir or at another location in fluid communication with the circulation gas flow path downstream of the reservoir and upstream of the optical pumping cell. The dispensing can be carried out while the optical pumping cell is actively operating to polarize target gas held therein **(block 117)**. As the reservoir is held at ambient temperature, there is no need to cool the polarized gas before dispensing from the reservoir or downstream thereof as noted above. In operation, the circulating gas flow path, the optical cell and the reservoir can all be maintained at a common system pressure, typically between about 0.6-1·0MPa(6-10 atm) and more typically about 0.8-1·0MPa (8-10 atm). However, pressures of up to between about 2.0-3·0MPa (20-30 atm) maybe used with suitable hardware. During set-up, the system can be charged to be at the desired system pressure by adding suitable amounts of target and supplemental gases.

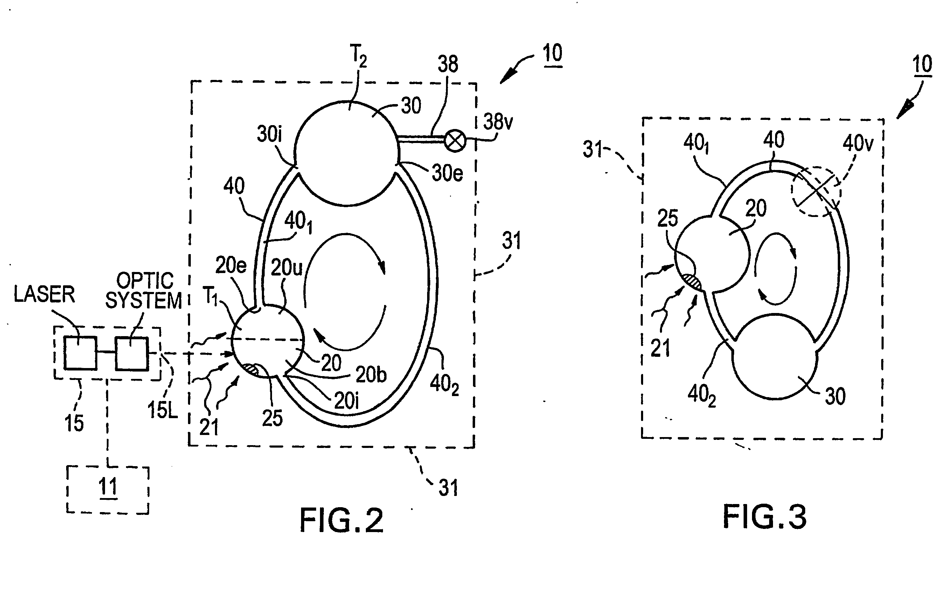

Turning now to **Figure 2**, one example of a hyperpolarizer system **10** is shown. In this embodiment, the system **10** includes an optic system **15** that generates and transmits polarized light **15L**, an optical pumping cell **20**, a reservoir **30**, a circulating gas flow path **40** and a magnetic field **31** generated by a magnetic field source. The magnetic field **31** can be configured with a low field strength having a field size and sufficient homogeneity to extend to cover both the optical pumping cell **20** and the holding cells **30**. In operation, the gas flows in the direction illustrated by the arrow drawn in the center of the figure. The flow direction can be changed by altering the configuration of the reservoir **30** with respect to the optical pumping cell **20**.

The optical pumping cell **20** includes opposing top and bottom portions **20u**, 20b, located on opposite sides of a line drawn through the center of the cell **20**. A small quantity of alkali metal **25**, such as rubidium, can be positioned in the cell **20** for conversion into a vapor during spin-exchange. The cell **20** includes an exit port **20e** and a spaced apart inlet port **20i**. The exit port **20e** should be positioned on the upper portion **20u** of the cell **20** to take advantage of the convection-induced discharge of the heated polarized gas from the cell **20**. That is, as hot polarized gas rises, it will flow out of the exit port **20e** and into the gas flow path **40** as it advances to the reservoir **30** (at a reduced temperature relative to the optical pumping cell **20**). The exit port **20e** should be positioned above the inlet **20i** on the cell body and each port can operate at the same pressure. The optical pumping cell **20** may be sized with an internal volume of between about 100-500 cc's, and is typically about 250 cc's. In certain embodiments, the optical pumping cell **20** and reservoir **30** can be shaped to be substantially spherical to increase the ratio of surface area to volume of the container. However, other shapes may be used where appropriate.

The reservoir **30** includes a gas flow inlet **30i** and a spaced apart outlet **30e**. The reservoir **30** is configured with a volume that is increased relative to the optical pumping cell **20** so that it is able to hold several successive polarized batches of gas therein while releasing polarized gas from the exit port **30e** (or a dispensing port **38**. For example, for a system 10 that includes an optical pumping cell **20** having a volume of between about 100-500 cc's, the reservoir can be sized to be about 1.5-4 times the size of the cell **20**, and typically 2-3 times the size of the cell **20**, for example, the reservoir **30** can be between about 300-1000 cc's, or greater.

The reservoir **30** may be cooled or be at ambient temperature. In any event, the reservoir **30** is held at a temperature (T₂) that is less than that of the optical pumping cell **20** and/or gas therein (T₁) to provide a desired thermal gradient in the closed loop system. As noted above, the heat **21** to the optical pumping cell can be supplied by any suitable source to provide the desired T₁ and/or thermal gradient The source should be configured to inhibit the decay of polarized gas. As nonlimiting examples, the source may be blown hot air, a surface wrap heater, laser energy (from the polarizing instrumentation or supplemental energy source), and the like. An insulating oven (not shown) may be positioned over the optical pumping cell **20**. For example, the optical cell **20** can be housed in a re-circulating oven configuration that holds a heating element in a remote location and blows forced hot air to the cell **20** to inhibit any depolarizing influences from proximity of the gas (not shown). In other embodiments, the laser energy is captured in a thermally insulated oven space, providing a substantially self-heating configuration that harnesses the heat released by the optical pumping process.

The heated polarized gas exits the top portion of the optical pumping cell **20** and travels in the gas flow path **40** to the reservoir **30**. The reservoir **30** may be located above the cell **20 (****Figure 2****)** or below the reservoir **30** (Figure 3). The reservoir **30** may also be located at the same height with the gas flow segment **40₁** rising out of the optical pumping cell **20** to connect it to the reservoir **30** (not shown).

The gas flow path **40** may be configured from a small diameter tubing or conduit configured to withstand the desired system pressures. The small diameter tubing may have about a 6·35mm (0.25-inch) diameter or less. The gas flow path **40** can be sized to provide a desired flow rate of the gas traveling in the closed loop circulation path 40. The gas flow path **40** can be formed from any suitable polarization decay-inhibiting material such as an aluminosilicate or sol-gel coated glass tube. Other suitable materials may also be used, such as, but not limited to, anodized aluminum.

The gas flow path **40** may be sized with a first flow segment **40₁** that has a smaller length and/or a reduced volume between the optical pumping cell 20 and the reservoir **30** (the outbound leg) relative to a second flow segment **40₂**, extending between the reservoir **30** and the optical pumping cell **20** (the return leg). This configuration may reduce the amount of polarization decay that the polarized gas experiences as it travels to the reservoir **30**. In other embodiments, the legs **40₁, 40₂** can be substantially the same length, or, as shown in **Figure 3**, the second (return) leg **40₂** can be shorter.

In certain embodiments, the inlet **30i** of the reservoir **30** is spaced apart at least about 5·08cm(2 inches) from the exit port **20e** of the optical pumping cell **20**. In particular embodiments, the first leg of the gas flow path **40₁** can be about 5·08-7·62cm (2-3 inches long). In addition, the second leg of the gas flow path **40₂** may be about 3-6 times the length of the first leg **40₁**. For example, the second leg **40₂** can be about 35·56cm (14 inches) long.

The associated gas flow path **40** (comprising legs **40₁** and **40₂**) in the system 10 may have a volume that is substantially less than that of the combined volumes of the reservoir **30** and cell **20**. Substantially less means that the flow path may have a volume that is about 10% the total flow path volume of the system. The total flow path volume includes the volume of the legs **40₁, 40₂** and the volume of the reservoir **30** and cell **20**. For example, the slow path volume **40** when measured to exclude the cell **20** and reservoir **30** can be about **15** cc's when the flow path **40** with the cell **20** and reservoir can have a volume of between about 500-1250 cc's.

The cross-sectional width of the first leg **40₁** may be sized to be different than the second leg **40₂** for flow rate purposes. In other embodiments, the first and second legs **40₁, 40₂** may be configured to be substantially the same cross-sectional width.

**Figure 3** also illustrates that the gas flow path **40** may include an optional flow control valve **40V**. The valve **40V** can be positioned in advance of the reservoir, after the reservoir **30** in advance of the optical pumping cell **20**. In lieu of one valve, a plurality of valves can also be used along the gas flow path **40** (not shown). Polarization friendly valves should be used, particularly upstream of the reservoir **30** and downstream of the cell **20**, where maintenance of the polarization strength is desired.

In certain embodiments, the circulating gas flow path **40** can be configured to provide a flow rate of about 50 cc's/min from the optical cell **20** to the reservoir **30** and/or from the reservoir **30** to the optical cell **20**. In particular embodiments, the entire closed loop path **40** (the closed loop gas flow path includes the cell **20** and the reservoir **30**) are held at the same pressure and the gas travels in the flow path **40** with a substantially constant flow rate.

**Figure 2** illustrates that a dispensing port **38** and associated dispensing valve **38V** may be positioned on the reservoir **30** to allow polarized gas to be dispensed into a desired delivery container. The dispensing port **38** may also be located downstream or upstream of the reservoir **30** in fluid communication with the gas flow path **40**. Placing the dispensing port at the reservoir **30** (or downstream but in proximity thereto) can allow the polarized gas to be cooled prior to dispensing (no longer requiring the polarization cell **20** to be cooled after batch production of ³He). Because the optical pumping cell does not have to be cooled between batches of polarized gas, the optical pumping cell can produce additional amounts of polarized gas, thereby obviating the "down-time" associated with cool down therein.

After dispensing, additional target gas or a target gas blend can be added to the gas flow path **40** to replace the dispensed polarized gas. As such, a filling port (not shown) may be connected to the gas flow path **40** used to controllably re-supply the closed loop system. Thus, as noted before, the gas flow path **40** can be operably associated with one or more (automated) valves (identified with the letter "V") in the travel path to allow for refill, dispensing, and/or to control the flow rate, pressure and the like of the gas in the closed loop system. In other embodiments, gas can continue to circulate at lower pressures and flow rates until substantially all of the polarized gas is dispensed. Then, the entire system **10** can be refilled.

As shown in **Figure 2**, the polarization and/or flow of the gas is automated and controlled by a controller **11**. The controller **11** may also include computer program code with instructions that control the sequencing of operations and/or the activation of the optic system **15**. The hyperpolarizer **10** may also include a gas flow path **40** and an associated dispense port **40p** that can allow the polarized gas **50p** to be dispensed. The controller **11** is configured to automatically monitor the polarization level of the polarized gas in one or both of the optical pumping cell **20** and the reservoir **30**. Further, the controller **11** may prohibit dispensing polarized gas that has decayed below a desired polarization level proximate in time to a planned and/or requested dispensing output. The controller **11** can monitor the temperature at certain locations in the closed loop circulation flow path and direct the adjustment (increase or decrease) of the temperature of either or both of the optical pumping cell or the reservoir to provide the desired thermal gradient and/or to increase or decrease the thermal gradient to increase or decrease the flow rate in the closed loop path **40**.

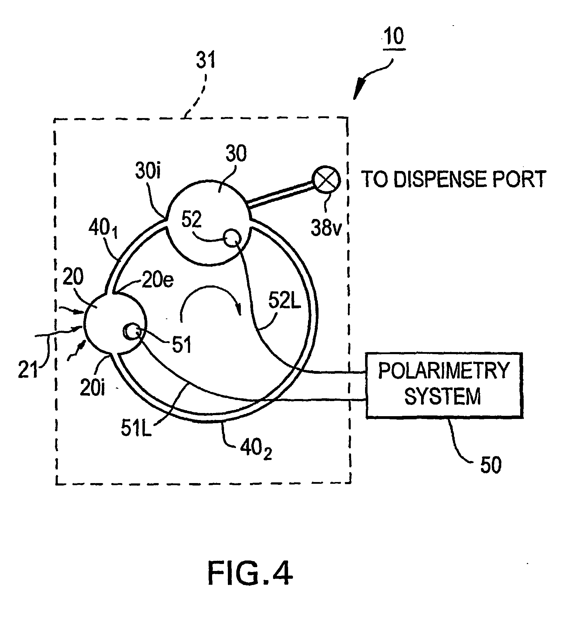

**Figure 4** illustrates that the system 10 can include NMR coils **51, 52** and associated leads, **51L, 52L**, respectively extending from the coils to a polarimetry system **50**. It is noted that polarimetry systems are well known to those of skill in the art. The polarization strength of the polarized gas can be monitored using polarimetry and the RF polarimetry coil(s) **51, 52***. See, e.g.,* U.S. Patent No. 6,295,834 and U.S. Patent No. 6,566, 875(published 20.05.03), and Saam et al., Low Frequency NMR Polarimeter for Hyperpolarized Gases, Jnl. of Magnetic Resonance 134, 67-71 (1998)

The magnetic field **31** shown by the broken lines in **Figures 2-4**, which covers the optical pumping cell **20** and the reservoir **30**, can be provided by any suitable magnetic field source, such as permanent magnets or electromagnets. A low magnetic field strength can be used, typically about 0·05T (500 Gauss) or less, and more typically about 0·01T (100 Gauss) or less, with sufficient homogeneity to inhibit depolarizing influences during production and storage of the polarized target gas. In particular embodiments, a field strength of between 0·7-2·0mT (7-20 Gauss) may be appropriate. In certain embodiments, a magnetic field homogeneity on the order of 10⁻⁷cm⁻¹T (Gauss)) is desirable, at least for the regions covering hyperpolarized gas for any length of time. Conventionally, Helmholtz coils have been used. The magnetic field **31** can also be configured to extend a distance sufficient to cover the gas dispensing port **38 (****Figure 2****)**. In particular embodiments, the magnetic field **31** may be further generated, formed or shaped to extend to cover the receiving containers of polarized gas during dispensing (not shown).

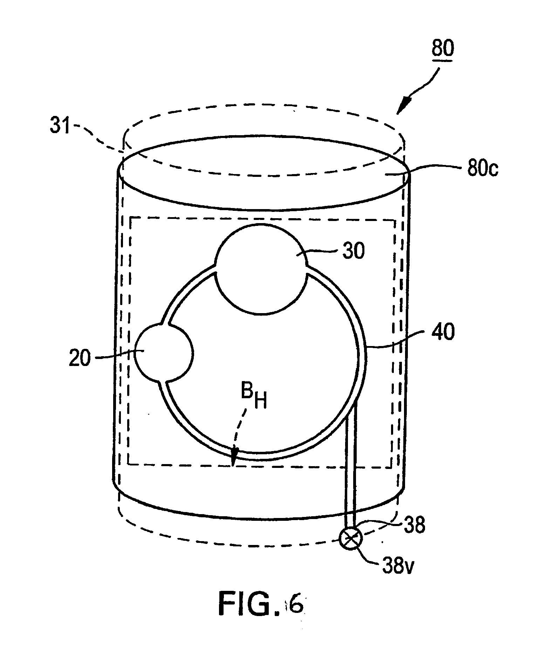

Thus, the field source may be a pair of Helmholtz coils, as is well known to those of skill in the art and/or permanent magnets. In certain embodiments, as shown in **Figure 6**, the field source is a cylindrical solenoid **80** that is configured to generate the magnetic field **31**. The solenoid **80** can include a cavity **80c** that is sized and configured to surround the optical pumping cell **20** and reservoir **30**. The polarized gas can be dispensed by directing the gas to flow or dispense out the dispensing port **38** from the hyperpolarizer substantially along the axis of the solenoid **80**. Other dispensing configurations can also be used. The solenoid **80** may be configured with 648 full winding layers and 58 extra layers of windings (16-gauge wire) on each end portion (for a total of 1528 windings) providing an ellipsoid shaped magnetic field of about 20·32cm (8 inches) wide and 45·72cm (18 inches) long. The solenoid can be configured with about 1·05km (3440 feet) of wire (about 14.4 Ohms). Using 1.0 amp and 15V, a field of about 1·87mT(18.7 Gauss) with sufficient size and homogeneity can be generated. Permanent magnet configurations are described in WO 01/11285 A1

The reservoir **30,** optical pumping cell **20,** and flow path **40** therebetween, are all held within a region of sufficient homogeneity within a single common magnetic holding field **B_{H}** inside the cavity of the solenoid as shown in **Figure 6****.** In other embodiments, a plurality of separate magnetic field sources or generators (all electromagnets, all permanent magnets, or combinations of each) can be used, to provide the desired holding fields for the hyperpolarizer (not shown).

The cell **20** can be configured for producing the same type of hyperpolarized target gas, typically a noble gas, such as, but not limited to ³He or ¹²⁹Xe.

Before or during initial start-up, the closed loop system **10** can be filled or charged with target gas (typically a gas mixture) so that the cell **20** is above atmospheric pressures, typically at about 0.76MPa (10 psi) at room temperature. In operation, the cell can operate at elevated pressures such as between about 0.6-10MPa (6-10 atm) as noted above. In certain particular embodiments, instead of pre-filling the cell **20** and engaging it wit the system **10,** the cell **20** can be filled with the desired target gas by directing a supply of exogenously held gas into the cell **20,** such as by using the dispensing path and/or port or a fill port and path (not shown). *See* US 2002/0069650 A1, US 2003/0108485 A1 (published 12.06.03), US 2003/0109058 A1 (published 12-06-03) (describing manifolds and filling and dispensing systems).

To recharge the closed loop system after dispensing all or portions of a batch or batches of polarized gas, the system **10** can be configured to allow exogenous (non-polarized gas) refills, such as by flowing target gas into the gas flow path 40, the reservoir, or the cell 20. Typically, the refill gas will be directed to enter the system **10** downstream of the reservoir so as not to dilute the polarized gas held therein.

Generally described, in operation, the optical pumping cell **20** is heated to an elevated temperature, generally to about 150-200°C or greater, and typically to about 180°C. The target gas mixture is polarized in the cell **20** at a pressure of between about 0·6-1.0MPa (6-10 atm). Of course, as is known to those of skill in the art, with hardware capable of operating at increased pressures, operating pressures of above 1·0MPa (10 atm), such as about 2·0-3·0MPa (20-30 atm), can be used to pressure-broaden the alkali metal absorption and promote spin exchange. Using increased pressures with an alkali metal (such as rubidium ("Rb")) can facilitate the absorption of the optical light (approaching up to 100%). In contrast, for laser line widths less than conventional line widths, lower pressures can be employed.

The optical pumping cell **20** typically includes a quantity of alkali metal **25 (****Figure 2****)** that vaporizes and cooperates to provide the spin-exchange polarization of the target gas of interest. The alkali metal can typically be used for a plurality of pumping procedures without replenishment. The optical pumping cell **20** has conventionally been formed from a substantially pure (substantially free of paramagnetic contaminants) aluminosilicate glass because of its ability to withstand deterioration due to the corrosive potential of alkali metal and its relatively friendly treatment of the hyperpolarized state of the gas (*i.e.*, "good spin relaxation properties"-so stated because of its ability to inhibit surface contact-induced relaxation attributed to collisions of the gas with the walls of the cell). Coatings such as sol-gel coatings, deuterated polymer coatings, metal film coatings and other coatings and materials that inhibit depolarization have also been proposed. *See, e.g.,* US 6551 559 B1 (published 22.04.03) and U.S. Patent No. 5,612,103 . The reservoir 30 may be formed of similar materials that inhibit polarization decay.

During polarization, the noble gas of choice (such as ³He) is held in the optical cell along with the alkali metal. The optical pumping cell is exposed to elevated pressures and heated in an oven to a high temperature as a light source, typically provided by a laser and/or laser array in an optic system **15 (****Figure 2****),** is directed into the optical cell 20 to optically pump the alkali metal and polarize the target gas.

The system **10** may employ helium buffer gas in the optical pumping cell 20 to pressure broaden the Rb vapor absorption bandwidth. The selection of a buffer gas can be important because the buffer gas -- while broadening the absorption bandwidth -- can also undesirably impact the alkali metal-noble gas spin-exchange by potentially introducing an angular momentum loss of the alkali metal to the buffer gas rather than to the noble gas as desired.

As will be appreciated by those of skill in the art, Rb is reactive with H₂O. Therefore, any water or water vapor introduced into the polarizer cell **20** can cause the Rb to lose laser absorption and decrease the amount or efficiency of the spin-exchange in the polarizer cell **20.** Thus, as an additional precaution, an extra filter or purifier (not shown) can be positioned before the inlet of the polarizer cell **20** with extra surface area to remove even additional amounts of this undesirable impurity in order to further increase the efficiency of the polarizer.

The hyperpolarizer system **10** can also capitalize on the temperature change in the line between the heated pumping cell **20** and the reservoir **30** or in the reservoir **30** itself to precipitate the alkali metal **25** from the polarized gas stream in the cell **20** and/or in the conduit proximate the cell **20** that forms a part of the gas flow path.

As will be appreciated by one of skill in the art, the alkali metal **25** can precipitate out of the gas stream at temperatures of about 40°C. The system **10** can also include an alkali metal reflux condenser (not shown) or post-cell filter (not shown). The refluxing condenser can employ a vertical refluxing outlet pipe, which is kept at room temperature. The gas flow velocity through the refluxing pipe and the size of the refluxing outlet pipe is such that the alkali metal vapor condenses and drips back into the pumping cell by gravitational force. Alternatively, and/or in addition, an Rb filter can be used to remove excess Rb from the hyperpolarized gas prior to collection or accumulation along the dispensing path or at the dispensing port **38 (****Figure** 2). In any event, it is desirable to remove alkali metal prior to delivering (and, typically, prior to dispensing from the hyperpolarizer) the polarized gas to a patient to provide a non-toxic, sterile, or pharmaceutically acceptable substance (*i.e.,* one that is suitable

As will be understood by those of skill in the art, in certain embodiments, the controller **11** can be configured to provide the purge/pump capacity from a central purge gas source and vacuum pump to the closed loop gas flow path **40** to clean the system of contaminants. As such, fluid flow paths of plumbing extending between the purge and vacuum sources to the optical pumping cell(s) **20** and/or reservoir **30** can be defined by a fluid distribution system or manifold network of plumbing, valves, and solenoids. These fluid flow paths selectively direct purge gas to and from the optical pumping cell **20** reservoir **30,** and closed loop gas flow path **40** to purge and evacuate the flow paths in order to prepare them for polarization operations or to hold or process polarized gas.

The quantity of target gas can be sized so as to provide the constituents commensurate with that needed to form a single batch. Typically, the unpolarized target gas is a gas mixture that comprises a minor amount of the target noble gas and a larger quantity of one or more high purity biocompatible filler gases. For example, for ³He polarization, an unpolarized gas blend of ³He/N₂ can be about 99.25/0.75. For producing hyperpolarized ¹²⁹Xe, the pre-mixed unpolarized gas mixture can be about 85-98% He (preferably about 85-89% He), about 5% or less ¹²⁹Xe, and about 1-10% N₂ (preferably about 6-10%).

Discrete amounts of polarized gas can be meted out of the reservoir **30** in quantities that provide a single patient amount for a single MRI imaging or NMR evaluation session. To provide the pharmaceutical grade polarized gas doses, the polarized gas itself may be mixed with pharmaceutical grade carrier gases or liquids upon dispensing, or may be configured to be administered as the only or primary substance or constituent. In particular embodiments, the polarized gas is ³He and is mixed with nitrogen filler gas prior to or during dispensing (or before administration to a patient) to form a volume of gas blend to be inhaled by the patient. In other embodiments, for example, for producing inhalable ¹²⁹Xe, the ¹²⁹Xe may form a major portion (or all) of the administered dose. In other embodiments, the polarized gas can be formulated to be injected *in vivo* (in a liquid carrier, in microbubble solution, or in gaseous form).

The hyperpolarizer system **10** can include one or more purifiers or filters (not shown) that are positioned in line with the plumbing to remove impurities such as water vapor, alkali metal, and oxygen from the system (or to inhibit their entry therein). The hyperpolarizer system **10** can also include various sensors including, a flow meter, as well as a plurality of valves, electrical solenoids, hydraulic, or pneumatic actuators that can be controlled by the controller **11** to define the fluid flow path and operation of the components of the hyperpolarizer **10.** As will be understood by those of skill in the art, other flow control mechanisms and devices (analog and electronic) may be used within the scope of the present invention. For additional descriptions of meted dispensing systems, *see* US 2003/01 084 85 A1 (published 12.06.03) and US 2003/01 09 058 A1 (published 12.06.03).

The hyperpolarizer system **10** can be located at the point of use site (hospital or clinic) typically in the vicinity of or proximate to the MRI or NMR equipment. That is, the hyperpolarizer system **10** can reside adjacent the MRI suite or in a room of a wing proximate thereto so as to limit the spatial transport and potential exposure to undesirable environmental conditions. In certain embodiments, the polarized gas transport time between the hyperpolarizer and the imaging suite is less than about 1 hour. Placing the hyperpolarizer in the clinic or hospital allows for short and consistent transport times procedure to procedure. In addition, formulating the pharmaceutical polarized gas with a polarized gas having higher levels of polarization can reduce the amount of the polarized gas used to form the end dose product, thereby potentially reducing the cost of the product.

Computer program code for carrying out operations of the present invention may be written in an object oriented programming language such as Java7, Smalltalk, Python, or C++. However, the computer program code for carrying out operations of the present invention may also be written in conventional procedural programming languages, such as the "C" programming language or even assembly language. The program code may execute entirely on the user's computer, partly on the user's computer, as a stand-alone software package, partly on the user's computer and partly on a remote computer or entirely on the remote computer. In the latter scenario, the remote computer may be connected to the user's computer through a local area network (LAN) or a wide area network (WAN), or the connection may be made to an external computer (for example, through the Internet using an Internet Service Provider).

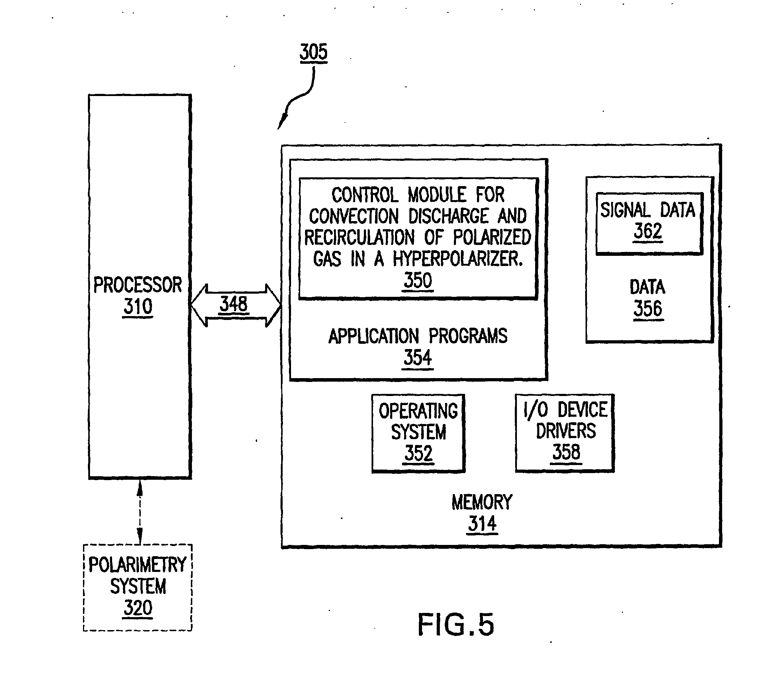

**Figure 5** is a block diagram of data processing systems for carrying out the present invention. The processor **310** communicates with the memory **314** via an address/data bus **348.** The processor **310** can be any commercially available or custom microprocessor. The memory **314** is representative of the overall hierarchy of memory devices containing the software and data used to implement the functionality of the data processing system **305.** The memory **314** can include, but is not limited to, the following types of devices: cache, ROM, PROM, EPROM, EEPROM, flash memory, SRAM, and DRAM.

As shown in **Figure 5**, the memory **314** may include several categories of software and data used in the data processing system **305:** the operating system **352;** the application programs **354;** the input/output (I/O) device drivers **358;** a background estimator module **350;** and the data **356.** The data **356** may include image data **362** which may be obtained from an image acquisition system **320. As** will be appreciated by those of skill in the art, the operating system **352** may be any operating system suitable for use with a data processing system, such as OS/2, AIX or OS/390 from International Business Machines Corporation, Armonk, NY, WindowsXP, WindowsCE, WindowsNT, Windows95, Windows98 or Windows2000 from Microsoft Corporation, Redmond, WA, PalmOS from Palm, Inc., MacOS from Apple Computer, UNIX, FreeBSD, or Linux, proprietary operating systems or dedicated operating systems, for example, for embedded data processing systems.

The I/O device drivers **358** typically include software routines accessed through the operating system **352** by the application programs **354** to communicate with devices such as I/O data port(s), data storage **356** and certain memory **314** components and/or the image acquisition system **320.** The application programs **354** are illustrative of the programs that implement the various features of the data processing system **305** and preferably include at least one application that supports operations of the present invention. Finally, the data **356** represents the static and dynamic data used by the application programs **354,** the operating system **352,** the I/O device drivers **358,** and other software programs that may reside in the memory **314.**

The Module **350** may also be incorporated into the operating system **352**, the I/O device drivers 358 or other such logical division of the data processing system 305.

The Control Module for Convection Discharge and Recirculating (Closed loop flow path) Polarized Gas Hyperpolarizers **350** can include computer program code for tracking polarization level data in the optical pumping cell and/or the reservoir and noting when the reservoir holds polarized gas that has decayed sufficiently that it is ready to be repolarized or is not suitable for use. The dispense can be prohibited if the polarization level is unduly low or an alternate dispense port may be activated (i.e., one upstream of the reservoir where fresher polarized gas can reside). The Module **350** can direct initiation of operations that will automatically determine and/or initiate controller operations that will do one or more of the following: (a) adjust the temperature in the pumping cell; (b) release polarized gas from the reservoir to a dispensing port; (c) adjust the flow rate of the gas in the closed loop path by adjusting the thermal gradient in the flow path or the valve positions of one or more flow valves; and (d) initiate replenishment or recharging of the closed loop path

The I/O data port can be used to transfer information between the data processing system **305** and the NMR polarimetry system **320** or another computer system, a network (e.g., the Internet) or other device controlled by the processor.
These components are conventional components such as those used in many conventional data processing systems.

The flowcharts and block diagrams of certain of the figures herein illustrate the architecture, functionality, and operation of possible implementations of probe cell estimation means. In this regard, each block in the flow charts or block diagrams represents a module, segment, or portion of code, which comprises one or more executable instructions for implementing the specified logical function(s). Certain of the flowcharts and block diagrams illustrate methods to operate hyperpolarizers or components thereof to yield polarized gas . In this regard, each block in the flow charts or block diagrams represents a module, segment, or portion of code, which comprises one or more executable instructions for implementing the specified logical function(s). It should also be noted that in some alternative implementations, the functions noted in the blocks may occur out of the order noted in the figures. For example, two blocks shown in succession may in fact be executed substantially concurrently or the blocks may sometimes be executed in the reverse order, depending upon the functionality involved.

## Claims

1. A method for producing hyperpolarized gas, comprising:
heating an optical pumping cell (20) containing a noble gas and an alkali metal, the optical pumping cell (20) having an exit port (20e) residing in a top portion (20u) of the optical pumping cell (20) and an inlet port (20i) positioned about a bottom portion (20b) of the optical pumping cell (20), the optical pumping cell (20) being connected, by means of a gas flow path (40), to a storage reservoir (30) having separate exit and inlet ports (30e, 30i), the gas flow path (40) extending from the optical pumping cell exit port (20e) to the reservoir inlet port (30i) and the reservoir exit port (30e) to the optical pumping cell inlet port (20i);
optically pumping, within a magnetic field, the alkali metal in the optical pumping cell (20), so that the noble gas in the optical pumping cell (20) becomes nuclear spin polarized *via* spin-exchange with the optically pumped alkali metal;
directing heated polarized gas to flow out of the top portion (20u) of the optical pumping cell (20) *via* said gas flow path (40) and the inlet port of the storage reservoir (30) into a storage reservoir (30), the storage reservoir (30) having a temperature (T₂) that is less than the temperature (T₁) of the optical pumping chamber (20), and the storage reservoir (30) having a greater volume than the optical pumping cell (20), wherein said directing is carried out using only convective heating of the polarized target gas;
automatically monitoring the polarization level of the polarized gas in one or both of the optical pumping cell (20) and the storage reservoir (30);
dispensing polarized gas (50p) from a dispensing port (38) positioned on the reservoir (30) or at a location of the gas flow path (40) downstream of the storage reservoir in advance of the optical pumping cell;
directing previously polarized gas from the storage reservoir (30), not dispensed *via* the dispensing port (38), back into the optical pumping cell (20) via said gas flow path (40) and said inlet port (20e) of the optical pumping cell (20); and,
generating a magnetic holding field (31) that covers the optical pumping cell (20), the reservoir (30) and the gas flow path (40).

2. A method according to Claim 1, wherein the optical pumping cell (20) is heated to above about 150 degrees Celsius, and the reservoir (30) is at room temperature.

3. A method according to Claim 1 or Claim 2, wherein the noble gas is ³He.

4. A method according to any one of Claims 1-3, wherein the dispensing step is carried out during the polarizing step.

5. A method according to any one of claims 1-4, wherein the gas flow path (40), the reservoir (30) and the optical pumping cell (20) are held at a pressure of about 8-10 x 101.325 kPa (8-10 atm).

6. A polarizing system (10) for polarizing a noble gas via spin-exchange with an optically pumped alkali metal (25), comprising:
an optical pumping cell (20) having an exit port (20e) residing on a top portion (20u) of the optical pumping cell (20) and an inlet port (20i) positioned about a bottom portion (20b) of the optical pumping cell (20);
a storage reservoir (30) in fluid communication with the optical pumping cell (20), the reservoir (30) having separate exit and inlet ports (30e, 30i), wherein the reservoir (30) has a larger volume than the optical pumping cell (20);
a gas flow path (40) extending from the optical pumping cell exit port (20e) to the storage reservoir inlet port (30i) and the storage reservoir exit port (30e) to the optical pumping cell inlet port (20i);
means arranged to generate a magnetic holding field covering the optical pumping cell (20), the reservoir (30), and the gas flow path (40);
an optic system arranged to generate and transmit polarized light for optical pumping an alkali metal within the optical pumping cell;
means for heating (21) said optical pumping cell (20) such that said optical pumping cell can be held at a temperature that is larger than the temperature of the storage reservoir (30);
a controller (11) configured to automatically monitor the polarization level of the polarized gas in one or both of the optical pumping cell (20) and the reservoir (30); and,
a dispensing port (38) for dispensing polarized noble gas, positioned on the reservoir (30) or at a location in the gas flow path (40) downstream of the storage reservoir (30) in advance of the optical pumping cell (20), so that, in operation, noble gas polarized in the optical pumping cell (20) convectively flows out of the optical pumping cell inlet port (20i) *via* the gas flow path (40) and the storage reservoir inlet port (30i) to the storage reservoir (30); and previously polarized noble gas which as not been dispensed *via* the dispensing port (38) automatically flows from the storage reservoir back into the optical pumping cell (20) *via* the gas flow path and said optical pumping inlet port (20i).

7. A system (10) according to Claim 6, further comprising a quantity of alkali metal (25) held in the optical pumping cell (20).

8. A system (10) according to Claim 6 or Claim 7, further comprising a quantity of target noble gas held in the optical pumping cell (20) for polarization.

9. A system (10) according to any one of Claims 6 to 8, further comprising a thermal source configured to heat the optical pumping cell (20) to above about 150 degrees Celsius.

10. A system (10) according to Claim 8, wherein the target noble gas is ³He.

11. A system (10) according to any one of Claims 6 to 11, further comprising an RF surface coil (51, 52) held on the reservoir (30) and/or an KF surface coil held on the optical pumping cell (20) for determining the polarization level of the polarized gas held therein.

## Patentansprüche

1. Verfahren zur Herstellung von hyperpolarisiertem Gas, umfassend:
Heizen einer optischen Pumpzelle (20), die ein Edelgas und ein Alkalimetall enthält, wobei die optische Pumpzelle (20) eine Austrittsöffnung (20e) aufweist, die sich in einem oberen Abschnitt (20u) der optischen Pumpzelle (20) befindet, und eine Einlassöffnung (20i), die an einem unteren Abschnitt (20b) der optischen Pumpzelle (20) positioniert ist, wobei die optische Pumpzelle (20), mittels eines Gasströmungspfads (40), an ein Speicherreservoir (30) mit separater Austritts- und Einlassöffnung (30e, 30i) angeschlossen ist, wobei sich der Gasströmungspfad (40) von der Austrittsöffnung (20e) der optischen Pumpzelle zur Reservoireinlassöffnung (30i) und von der Reservoiraustrittsöffnung (30e) zur Einlassöffnung (20i) der optischen Pumpzelle erstreckt;
optisches Pumpen, innerhalb eines Magnetfelds, des Alkalimetalls in der optischen Pumpzelle (20), so dass das Edelgas in der optischen Pumpzelle (20) Kernspin-polarisiert wird via Spinaustausch mit dem optisch gepumpten Alkalimetall;
Leiten von erhitztem polarisierten Gas so, dass es aus dem oberen Abschnitt (20u) der optischen Pumpzelle (20) via den Gasströmungspfad (40) und die Einlassöffnung des Speicherreservoirs (30) in ein Speicherreservoir (30) strömt, wobei das Speicherreservoir (30) eine Temperatur (T₂) aufweist, die niedriger ist als die Temperatur (T₁) der optischen Pumpkammer (20), und das Speicherreservoir (30) ein größeres Volumen besitzt als die optische Pumpzelle (20), wobei das Leiten lediglich mittels konvektiven Erhitzens des polarisierten Zielgases erfolgt;
automatisches Überwachen des Polarisationsgrads des polarisierten Gases in einem oder beiden von der optischen Pumpzelle (20) und dem Speicherreservoir (30);
Ausgeben von polarisiertem Gas (50p) aus einer Ausgabeöffnung (38), die auf dem Reservoir (30) oder an einer Stelle des Gasströmungspfads (40),
nachgeordnet dem Speicherreservoir, vor der optischen Pumpzelle positioniert ist;
Leiten zuvor polarisierten Gases aus dem Speicherreservoir (30), das nicht via die Ausgabeöffnung (38) ausgegeben wird, zurück in die optische Pumpzelle (20) via den Gasströmungspfad (40) und die Einlassöffnung (20e) der optischen Pumpzelle (20); und
Erzeugen eines magnetischen Haltefelds (31), das die optische Pumpzelle (20), das Reservoir (30) und den Gasströmungspfad (40) erfasst.

2. Verfahren nach Anspruch 1, wobei die optische Pumpzelle (20) auf über etwa 150 Grad Celsius geheizt wird und das Reservoir (30) sich auf Raumtemperatur befindet.

3. Verfahren nach Anspruch 1 oder Anspruch 2, wobei das Edelgas ³He ist.

4. Verfahren nach einem der Ansprüche 1-3, wobei der Ausgabeschritt während des Polarisationsschritts ausgeführt wird.

5. Verfahren nach einem der Ansprüche 1-4, wobei der Gasströmungspfad (40), das Reservoir (30) und die optische Pumpzelle (20) unter einem Druck von etwa 8-10x101,325 kPa (8-10 atm) gehalten werden.

6. Polarisationssystem (10) zum Polarisieren eines Edelgases via Spinaustausch mit einem optisch gepumpten Alkalimetall (25), umfassend:
eine optische Pumpzelle (20) mit einer Austrittsöffnung (20e), die sich auf einem oberen Abschnitt (20u) der optischen Pumpzelle (20) befindet, und
einer Einlassöffnung (20i), die an einem unteren Abschnitt (20b) der optischen Pumpzelle (20) positioniert ist;
ein Speicherreservoir (30) in fluider Kommunikation mit der optischen Pumpzelle (20), wobei das Reservoir (30) eine separate Austritts- und
Einlassöffnung (30e, 30i) aufweist, wobei das Reservoir (30) ein größeres Volumen als die optische Pumpzelle (20) besitzt;
einen Gasströmungspfad (40), der sich von der Austrittsöffnung (20e) der optischen Pumpzelle zur Speicherreservoir-Einlassöffnung (30i) und von der Speicherreservoir-Austrittsöffnung (30e) zur Einlassöffnung (20i) der optischen Pumpzelle erstreckt;
Mittel, die angeordnet sind, um ein magnetisches Haltefeld zu erzeugen, das die optische Pumpzelle (20), das Reservoir (30) und den Gasströmungspfad (40) erfasst;
ein optisches System, das angeordnet ist zum Erzeugen und Aussenden polarisierten Lichts zwecks optischen Pumpens eines Alkalimetalls innerhalb der optischen Pumpzelle;
Mittel (21) zum Heizen der optischen Pumpzelle (20) so, dass die optische Pumpzelle auf einer Temperatur gehalten werden kann, die größer ist als die Temperatur des Speicherreservoirs (30);
eine Steuer- bzw. Regeleinrichtung (11), die ausgelegt ist, um den Polarisationsgrad des polarisierten Gases in einem oder beiden von der optischen Pumpzelle (20) und dem Reservoir (30) automatisch zu überwachen; und
eine Ausgabeöffnung (38) zum Ausgeben polarisierten Edelgases, die auf dem Reservoir (30) oder an einer Stelle im Gasströmungspfad (40), nachgeordnet dem Speicherreservoir (30), vor der optischen Pumpzelle (20) positioniert ist, so dass, bei Betrieb, in der optischen Pumpzelle (20) polarisiertes Edelgas konvektiv aus der Einlassöffnung (20i) der optischen Pumpzelle via den Gasströmungspfad (40) und die Speicherreservoir-Einlassöffnung (30i) zum Speicherreservoir (30) strömt; und zuvor polarisiertes Edelgas, das nicht via die Ausgabeöffnung (38) ausgegeben worden ist, automatisch aus dem Speicherreservoir zurück in die optische Pumpzelle (20) via den Gasströmungspfad und die Einlassöffnung (20i) der optischen Pumpzelle strömt.

7. System (10) nach Anspruch 6, weiterhin umfassend eine in der optischen Pumpzelle (20) enthaltene Alkalimetall-(25)-Menge.

8. System (10) nach Anspruch 6 oder Anspruch 7, weiterhin umfassend eine in der optischen Pumpzelle (20) zwecks Polarisation enthaltene Zieledelgasmenge.

9. System (10) nach einem der Ansprüche 6 bis 8, weiterhin umfassend eine Wärmequelle, die ausgelegt ist, um die optische Pumpzelle (20) auf über etwa 150 Grad Celsius zu heizen.

10. System (10) nach Anspruch 8, wobei das Zieledelgas ³He ist.

11. System (10) nach einem der Ansprüche 6 bis 11, weiterhin umfassend eine auf dem Reservoir (30) gehaltene HF-Oberflächenspule (51, 52) und / oder eine auf der optischen Pumpzelle (20) gehaltene HF-Oberflächenspule zum Feststellen des Polarisationsgrads des darin enthaltenen polarisierten Gases.

## Revendications

1. Procédé de production de gaz hyperpolarisé, comprenant :
le chauffage d'une cellule de pompage optique (20) contenant un gaz noble et un métal alcalin, la cellule de pompage optique (20) comportant un orifice de sortie (20e) agencé sur une partie supérieure (20u) de la cellule de pompage optique (20) et un orifice d'entrée (20i) positionné au niveau d'une partie inférieure (20b) de la cellule de pompage optique (20), la cellule de pompage optique (20) étant raccordée, au moyen d'un trajet d'écoulement de gaz (40), à un réservoir de stockage (30) présentant des orifices de sortie et d'entrée séparés (30e, 30i), le trajet d'écoulement de gaz (40) s'étendant de l'orifice de sortie de cellule de pompage optique (20e) à l'orifice d'entrée de réservoir (30i) et de l'orifice de sortie de réservoir (30e) à l'orifice d'entrée de cellule de pompage optique (20i) ;
le pompage optique, dans un champ magnétique, du métal alcalin dans la cellule de pompage optique (20), de telle sorte que le gaz noble dans la cellule de pompage optique (20) présente un spin nucléaire polarisé par échange de spin avec le métal alcalin après son pompage optique ;
l'acheminement du gaz polarisé chauffé afin de le refouler de la partie supérieure (20u) de la cellule de pompage optique (20) par l'intermédiaire dudit trajet d'écoulement de gaz (40) et de l'orifice d'entrée du réservoir de stockage (30) dans un réservoir de stockage (30), le réservoir de stockage (30) présentant une température (T₂) qui est inférieure à la température (T₁) de la chambre de pompage optique (20), et le réservoir de stockage (30) présentant un volume supérieur à celui de la cellule de pompage optique (20), dans lequel ledit acheminement est mis en oeuvre en utilisant uniquement un chauffage par convection du gaz cible polarisé ;
la surveillance automatique du niveau de polarisation du gaz polarisé dans l'un de la cellule de pompage optique (20) et du réservoir de stockage (30) ou dans les deux ;
la distribution du gaz polarisé (50p) à partir d'un orifice de distribution (38) positionné sur le réservoir (30) ou à un emplacement du trajet d'écoulement de gaz (40) en aval du réservoir de stockage avant la cellule de pompage optique ;
l'acheminement du gaz préalablement polarisé à partir du réservoir de stockage (30), non distribué par l'orifice de distribution (38), de nouveau dans la cellule de pompage optique (20) par l'intermédiaire dudit trajet d'écoulement de gaz (40) et dudit orifice d'entrée (20e) de la cellule de pompage optique (20) ; et,
la production d'un champ magnétique de maintien (31) qui recouvre la cellule de pompage optique (20), le réservoir (30) et le trajet d'écoulement de gaz (40).

2. Procédé selon la revendication 1, dans lequel la cellule de pompage optique (20) est chauffée à une température supérieure à 150 degrés Celsius environ, et le réservoir (30) est à la température ambiante.

3. Procédé selon la revendication 1 ou 2, dans lequel le gaz noble est du ³He.

4. Procédé selon l'une quelconque des revendications 1 à 3, dans lequel l'étape de distribution est mise en oeuvre au cours de l'étape de polarisation.

5. Procédé selon l'une quelconque des revendications 1 à 4, dans lequel le trajet d'écoulement de gaz (40), le réservoir (30) et la cellule de pompage optique (20) sont maintenus à une pression de 8 à 10 x 101,325 kPa environ (8 à 10 bars).

6. Dispositif de polarisation (10) destiné à polariser un gaz noble par échange de spin avec un métal alcalin après son pompage optique (25), comprenant :
une cellule de pompage optique (20) comportant un orifice de sortie (20e) agencé sur une partie supérieure (20u) de la cellule de pompage optique (20) et un orifice d'entrée (20i) positionné autour d'une partie inférieure (20b) de la cellule de pompage optique (20) ;
un réservoir de stockage (30) en communication fluidique avec la cellule de pompage optique (20), le réservoir (30) comportant des orifices de sortie et
d'entrée séparés (30e, 30i), dans lequel le réservoir (30) présente un volume supérieur à celui de la cellule de pompage optique (20) ;
un trajet d'écoulement de gaz (40) s'étendant de l'orifice de sortie de cellule de pompage optique (20e) à l'orifice d'entrée de réservoir de stockage (30i) et de l'orifice de sortie de réservoir de stockage (30e) à l'orifice d'entrée de cellule de pompage optique (20i) ;
un moyen agencé afin de produire un champ magnétique de maintien recouvrant la cellule de pompage optique (20), le réservoir (30) et le trajet d'écoulement de gaz (40) ;
un dispositif optique agencé afin de produire et de transmettre de la lumière polarisée de manière à assurer le pompage optique d'un métal alcalin à l'intérieur de la cellule de pompage optique ;
un moyen de chauffage (21) de ladite cellule de pompage optique (20) de telle sorte que ladite cellule de pompage optique peut être maintenue à une température qui est supérieure à la température du réservoir de stockage (30) ;
une unité de commande (11) configurée afin de surveiller de manière automatique le niveau de polarisation du gaz polarisé dans l'un ou les deux de la cellule de pompage optique (20) et du réservoir (30) ; et,
un orifice de distribution (38) destiné à distribuer le gaz noble polarisé, positionné sur le réservoir (30) ou à un emplacement sur le trajet d'écoulement de gaz (40) en aval du réservoir de stockage (30), avant la cellule de pompage optique (20), de telle sorte qu'en fonctionnement, le gaz noble polarisé dans la cellule de pompage optique (20) s'écoule par convection par l'orifice d'entrée de cellule de pompage optique (20i) par l'intermédiaire du trajet d'écoulement de gaz (40) et de l'orifice d'entrée de réservoir de stockage (30i) vers le réservoir de stockage (30) ; et du gaz noble préalablement polarisé qui lorsqu'il n'a pas été distribué par l'intermédiaire de l'orifice de distribution (38) s'écoule automatiquement à partir du réservoir de stockage de nouveau dans la cellule de pompage optique (20) par l'intermédiaire du trajet d'écoulement de gaz et dudit orifice d'entrée de pompage (20i).

7. Dispositif (10) selon la revendication 6, comprenant, en outre, une certaine quantité de métal alcalin (25) contenue dans la cellule de pompage optique (20).

8. Dispositif (10) selon la revendication 6 ou 7, comprenant, en outre, une certaine quantité de gaz noble cible contenue dans la cellule de pompage optique (20) en vue de sa polarisation.

9. Dispositif (10) selon l'une quelconque des revendications 6 à 8, comprenant, en outre, une source thermique configurée afin de chauffer la cellule de pompage optique (20) à une température supérieure à 150 degrés Celsius environ.

10. Dispositif (10) selon la revendication 8, dans lequel le gaz noble cible est du 3He.

11. Dispositif (10) selon l'une quelconque des revendications 6 à 10(), comprenant, en outre, une bobine de surface RF (51, 52) contenue dans le réservoir (30) et/ou une bobine de surface RF contenue dans la cellule de pompage optique (20) afin de déterminer le niveau de polarisation du gaz polarisé contenu à l'intérieur.
